# EUROPEAN PATENT APPLICATION

(11) **EP 0 534 278 A1**
(43) Date of publication of application: **31.03.1993**
(21) Application number: 92115740.0
(22) Date of filing: 15.09.1992
(51) Int. Cl.: H03D 7/16, H04N 7/20

(54) **High frequency converter**

(30) Priority: 26.09.1991 EP 91402578
(71) Applicant: THOMSON multimedia, 92400 Courbevoie (FR)
(72) Inventor: Fujimoto, Masahiro, F-67400 Illkirch (FR); Grimm, Jean-Paul, F-67400 Illkirch (FR); Maier, Gerhard, W-7735 Dauchingen (DE)
(74) Representative: Einsel, Robert, Dipl.-Ing.

(57) **Abstract**

The present invention relates to a high frequency converter, which is able to convert simultaneoulsly two high frequency bands into one single receive frequency band.

According to the present invention a double conversion is provided, whereby a first of the said high frequency band is just single converted and a second of the said high frequency bands is double converted.

The present invention is preferred to be taken for the reception of signals from the satellite KOPERNIKUS.

## Description

The present invention relates to a high frequency converter according to the generic part of claim 1.

It is known, e.g. from the French patent application FR 2 642 598, to convert high frequency signals, which e.g. may be received from a TV-satellite, from their original frequency band into a receive frequency band, which can be received by a rear positioned receiver.

The reception system presented by the said patent application, which includes a super high frequency head (tete hyperfrequence), a band converter and a receiver, is able to receive three frequency bands, which are for example, according to a preferred embodiment of the French application:
B1 10.95 - 11.70 GHz,
B2 11.70 - 12.50 GHz,
B3 12.50 - 12.75 GHz.

The received signals are led to the super-high-frequency head, which contains a first and a second mixer with according oscillators. For receiving the range B1 a first path including the first mixer is used, for the frequency ranges B2, B3 a second path including the second mixer is used. The corresponding frequency ranges at the output of the superhigh-frequency head are
B1' 950 - 1700 MHz,
B2' 950 - 1750 MHz,
B3' 1750 - 2000 MHz.

These signals are led to the input of the converter, output of which is connected with the input of the receiver with a frequency range of 950 - 1750 MHz.

As the ranges B1' and B2' are inside the frequency range of the receiver, according signals can be linked directly, via a line to the receiver. Signals inside the range B3' must be operated by additional converter means, which results to the range
B3'' 1215 - 1465 MHz,
which is inside the receive range of the receiver.

The reception system of the said application is characterized in that just one of the frequency bands to be led to the receiver is selected by switching one of the different paths, which may include one of the mixers or may even be a direct line.

With known converter systems it is not possible to receive simultaneously more than one frequency band.

It is an object of the present invention to present a high frequency converter, which is able to convert signals of a given frequency band including two or more frequency ranges in such a way, that signals in more than one frequency range can be received simultaneously with receiving means having a given receive frequency band.

This can be realized with the aid of the converter according to claim 1.

According to the invention, source signals having frequencies inside a frequency band with groups of frequency ranges are led to a first mixer, which convert the said source band into a first converted band. This converted band is distributed on a first path and a second path.

The first path leads those ranges of the first converted band, which are inside the band of receiving means, without another conversion to the receiver input. The second path converts again ranges of the first converted band, which are outside of the receive frequency band in such a way that the twice converted ranges are inside the receive frequency band.

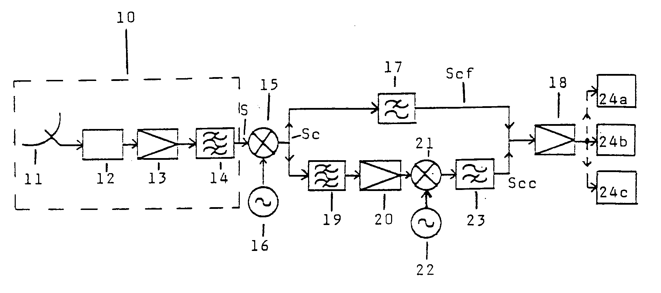

Further characteristics, advantages, and details of the invention will be explained in the following embodiments with the aid of accompanying drawings, wherein
- Fig. 1: shows a preferred embodiment of the invention.

Before the detailed description of the embodiments it may be mentioned that the blocks shown in the figure serve just for a better understanding of the invention. Some of these blocks may be integrated to units, which may be realized in integrated circuit (IC) technology or hybrid circuit technology.

The elements included in the single blocks may even be realized separately.

Fig. 1 shows a high frequency source 10, which includes in this embodiment a parabolic antenna 11, a polarization switch 12, a low noise amplifier (LNA) 13, and a first band-pass filter 14.

The signal S of the source 10 is led to a first mixer 15 linked to an according first local-oscillator 16 and converting the source signal S into a single converted signal Sc. The signal Sc is led on one hand via a first path including a low-pass filter 17, output of which is a converted and filtered signal Scf, which is led to the input of an intermediate frequency amplifier 18. On the other hand the signal Sc is led via a second path inluding a series connection of a second band-pass filter 19, an amplifier 20, a second mixer 21, which is connected to a second local-oscillator 22, and a high-pass filter 23. This results in a double converted signal Scc, which is led to the input of the intermediate frequency amplifier 18. The output of this amplifier 18 is connected to input terminals of one or more receivers 24, which may include known means for receiving, monitoring and/or displaying the information of the signals S.

With the aid of the parabolic antenna 11 signals, which may be transmitted from a non shown satellite, are received and the polarization switch 12 is provided to select a given polarization, which may be e.g. horizontal, vertical, clockwise or counterclockwise polarized. The LNA 13 amplifies and the band-pass filter 14 filters the given frequency band.

This results in the source signal S, which is in this embodiment inside a frequency band with the frequency ranges a, b, wherein
- a:: 11.45 - 11.70 Ghz and
- b:: 12.50 - 12.75 Ghz.

Though these frequencies belong to the range of the satellite "Kopernikus", the invention itself is not limited to converting satellite received signals.

The first local-oscillator 16 generates a signal of about 10 Ghz and the first mixer 15 converts the signal S into frequency ranges a', b' with
- a':: 1.45 - 1.70 Ghz and
- b':: 2.50 - 2.75 Ghz.

The receivers 24 have a receive frequency band r of
- r :: 0.95 - 1.75 Ghz.

That means, that the single converted signal Sc includes the first frequency range a', which is inside the receive range r and a second frequency range b', which is outside of the range r.

With the aid of the low-pass filter 17 the range a' is selected and the signal Scf includes solely the range a'.

With the aid of the second band-pass filter 19 the range b' is selected and according signals are amplified by the amplifier 20 and converted by the second mixer 21, oscillator 22 of which oscillates at 1.55 Ghz, into the range
- b'':: 0.95 - 1.2 Ghz.

The double converted signal Scc, which includes frequencies of this range b'', and the single converted and low-pass filtered signal Scf are amplified by the intermediate frequency amplifier 18 and according signals are led to the receivers 24.

As the receive frequency range r includes as well the range a' as the range b'', signals of the received ranges a and b can be selected simultaneously by the receivers 24.

That means for example that with the first receiver 24a a signal of the range a may be received and at the same time signals of the range b may be received by the second receiver 24b and/or the third receiver 24c.

On the other hand it is also possible, that one of the receivers 24, e.g. the first receiver 24a, receives signals of both ranges a and b, which may be shown on a common TV-screen with the aid of a picture-in-picture (PIP) system.

Versions of the the preferred embodiment may include at least one of the following variations:
- Other frequency bands may be received simultaneously. Frequency of the local-oscillators 16, 22 must be chosen appropriately;
- for the reception of a frequency band including more than two frequency ranges a third and perhabs other paths including appropriate converting means may be provided;
- the filters 17, 19, 23 may all be band-pass filters or high-pass or low-pass filters depending on the arrangement of the frequency ranges a', b', b''.
- the double conversion can be combined with switching between frequency ranges when several frequency ranges need to be received (but not all simultaneously).

## Claims

1. Highfrequency converter, which converts source signals (S) of a given frequency band with at least two frequency ranges (a,b) into a receive frequency band (r), which can be received by receiving means (24), including
- first converting means (15), which convert the said frequency band (a, b) into a first converted band (a', b' ) in such a way that at least one of the ranges (a') are receivable, which means they are inside the receive frequency range (r),
- second converting means (21), which convert non-receivable ranges (b') of the first converted band (a', b') into a double converted band (b'') such, that the information of at least one other of the frequency ranges (b) can be received by the receiving means (24),
characterised in that the first converted receivable frequency range (a') and further converted receivable frequency ranges (b'') do not overlap eachother.

2. Converter according to claim 1, characterised in that the frequency band (a, b) of the source signal (S) include the frequency ranges 11.45 - 11.7 Gigahertz and/or 12.50 - 12.75 Gigahertz.

3. Converter according one of the claims 1 or 2, characterised in that receive frequency band (r) includes the frequency range of 0.95 - 1.75 Gigahertz.
